# EUROPÄISCHE PATENTSCHRIFT

(11) **EP 0 588 296 B1**
(45) Veröffentlichungstag und Bekanntmachung des Hinweises auf die Patenterteilung: **27.11.1996**
(21) Anmeldenummer: 93114741.7
(22) Anmeldetag: 14.09.1993
(51) Int. Cl.: H01L 21/306, H01L 33/00

(54) **Verfahren zur Herstellung eines Bauelementes mit porösem Silizium**
Method of production of a porous silicon device
Méthode de fabrication d'un dispositif comportant du silicium poreux

(30) Priorität: 18.09.1992 DE 4231310
(43) Veröffentlichungstag der Anmeldung: 23.03.1994
(73) Patentinhaber: SIEMENS AKTIENGESELLSCHAFT, 80333 München (DE)
(72) Erfinder: Stengl, Reinhard, Dr., D-86391 Stadtbergen (DE); Hönlein, Wolfgang, Dr., D-82008 Unterhaching (DE); Lehmann, Volker, Dr., D-80689 München (DE); Spitzer, Andreas, Dr., D-85521 Ottobrunn (DE)

(56) Entgegenhaltungen:
- US-A- 3 954 523
- US-A- 4 092 445
- US-A- 4 532 700
- US-A- 5 023 200
- PATENT ABSTRACTS OF JAPAN vol. 9, no. 27 (E-294)6. Februar 1985 & JP-A-59 172 273 (TOUKOU KK) 28. September 1984
- JOURNAL OF THE ELECTROCHEMICAL SOCIETY Bd. 136, Nr. 2 , Februar 1989 , MANCHESTER, NEW HAMPSHIRE US Seiten 586 - 587 S.S. TAO ET AL. 'MULTILEVEL POROUS SILICON FORMATION'
- JOURNAL OF THE ELECTROCHEMICAL SOCIETY Bd. 138, Nr. 6 , Juni 1991 , MANCHESTER, NEW HAMPSHIRE US Seiten 1739 - 1743 S.S. TSAO ET AL 'POROUS SILICON FORMATION IN N-/N+/N- DOPED STRUCTURES'

## Beschreibung

Silizium ist ein indirekter Halbleiter mit einem Bandabstand von 1,1 eV. Daher erscheint die Herstellung von Halbleiterstrukturen zur Lichtemission im sichtbaren Spektralbereich auf der Basis von Silizium nicht möglich.

Aus V. Lehmann, U. Gösele, Appl. Phys. Lett. 58 (1991) S. 856 ist eine Untersuchung über die Herstellung von porösem Silizium bekannt. Durch anodisches Ätzen von einkristallinem Silizium in einem fluoridhaltigen, sauren Elektrolyten, in dem die Siliziumscheibe als Anode verschaltet ist, wird an der Oberfläche der Siliziumscheibe poröses Silizium gebildet. Poröses Silizium weist Poren oder Kanäle auf. Der Durchmesser der Kanäle ist abhängig von der Dotierung der Siliziumscheibe. Bei einer Dotierung der Siliziumscheibe im Bereich zwischen 10¹⁵ und 10¹⁸cm⁻³ entstehen Kanäle mit Durchmessern von 1 bis 2 nm. In Silizium mit einer Dotierung, die über 10¹⁹ cm⁻³ beträgt, entstehen Kanäle mit Durchmessern von 10 nm bis 100 nm.

Es wurde entdeckt (s. V. Lehmann, U. Gösele, Appl. Phys. Lett. 58 (1991), S. 856), daß poröses Silizium, das aus schwach dotiertem Silizium mit einer Dotierstoffkonzentration zwischen 10¹⁵ und 10¹⁸ cm⁻³ hergestellt wurde und daher Kanäle mit 1 bis 2 nm Durchmesser aufweist, einen Bandabstand von etwa 1,7 eV aufweist und Fotolumineszenz im sichtbaren Spektralbereich zeigt (s. L. T. Canham, Appl. Phys. Lett. 57 (1990), S. 1046 und N. Koshida et. al., Jap. J. Appl. Phys. 30 (1991), S. L1221). Dieses Material erscheint zur Herstellung von optischen Halbleiterbauelementen aus Silizium geeignet.

Als optisches Halbleiterbauelement mit porösem Silizium wurde bisher vorgeschlagen, eine Schicht aus porösem Silizium durch Aufdampfen von Gold mit Schottky-Kontakten zu versehen (s. Pressemeldung d. Fraunhofer Inst. IFT, Süddeutsche Zeitung Nr. 199, S. 37 vom 29.08.1991). Wegen der Porösität des porösen Siliziums ist das Aufdampfen von Metall schwierig.

Der Erfindung liegt das Problem zugrunde, ein Verfahren zur Herstellung eines Bauelementes mit porösem Silizium anzugeben, bei dem eine sichere Kontaktierung des porösen Siliziums gewährleistet ist.

Dieses Problem wird erfindungsgemäß gelöst durch ein Verfahren nach Anspruch 1.

Erfindungsgemäß werden in einer Siliziumscheibe zunächst zwei hochdotierte Gebiete und ein dazwischen angeordnetes, schwach dotiertes Gebiet gebildet. Die Dotierstoffkonzentration wird dabei in dem schwach dotierten Gebiet im Bereich zwischen 10¹⁵ und 10¹⁸ cm⁻³ eingestellt. In den hochdotierten Gebieten wird die Dotierstoffkonzentration auf Werte über 10¹⁹ cm⁻³ eingestellt. In einem fluoridhaltigen, sauren Elektrolyten, mit dem die Siliziumscheibe in Kontakt steht und in dem die Siliziumscheibe als Anode verschaltet ist, wird eine anodische Ätzung durchgeführt, bei der in dem schwach dotierten Gebiet das Silizium in poröses Silizium umgewandelt wird. Wegen der Dotierstoffkonzentration in dem schwach dotierten Gebiet entsteht dabei poröses Silizium mit Kanaldurchmessern um 1 bis 2 nm. Die hochdotierten Gebiete, in denen aufgrund der dort herrschenden Dotierstoffkonzentration allenfalls Kanäle mit Durchmessern im Bereich 10 nm bis 100 nm entstehen, sind mit dem porösem Silizium in dem schwach dotierten Gebiet fest verbunden. Die hochdotierten Gebiete sind daher geeignet als Anschlüsse zur Elektronen- bzw. Löcherinjektion in das dazwischenliegende poröse Silizium. Die hochdotierten Gebiete werden jeweils mit Kontakten versehen.

Die anodische Ätzung erfolgt vorzugsweise in verdünnter Flußsäure mit mindestens 5 Gewichtsprozent HF. Die Stromdichte wird im Bereich 1 bis 1000 mA/cm² eingestellt, die Spannung von einigen Volt ist abhängig von der eingestellten Stromdichte.

Ist das schwach dotierte Gebiet p-dotiert, so ist es vorteilhaft, die Siliziumscheibe während der anodischen Ätzung von der Rückseite her zu beleuchten.

Gemäß einer Ausführungsform der Erfindung wird an der Oberfläche eines Silizumsubstrats als erstes hochdotiertes Gebiet eine erste Schicht erzeugt, die von einem ersten Leitfähigkeitstyp dotiert ist und die eine Dotierstoffkonzentration von mindestens 10¹⁹ cm⁻³ aufweist. Durch Epitaxie wird auf der ersten Schicht eine zweite Schicht erzeugt, die von einem zweiten, zum ersten entgegengesetzten Leitfähigkeitstyp dotiert wird und die eine Dotierstoffkonzentration im Bereich zwischen 10¹⁵ und 10¹⁸ cm⁻³ aufweist. Die zweite Schicht bildet das schwach dotierte Gebiet. Das zweite hochdotierte Gebiet wird in Form einer dritten Schicht erzeugt, die vom zweiten Leitfähigkeitstyp dotiert ist und eine Dotierstoffkonzentration von mindestens 10¹⁹ cm⁻³ aufweist. Zur anodischen Ätzung wird die Oberfläche der dritten Schicht mit dem Elektrolyten in Kontakt gebracht. Dabei entstehen in der dritten Schicht Kanäle mit Durchmessern um 10 nm bis 100 nm. In der zweiten Schicht verzweigen sich die Kanäle zu Kanälen mit Durchmessern im Bereich 1 bis 2 nm. Auf diese Weise wird die zweite Schicht in poröses Silizium umgewandelt. Zum Anschluß der ersten Schicht wird z. B. durch maskierte Implantation ein tiefreichender Anschluß durch die dritte Schicht und die zweite Schicht hindurch vom ersten Leitfähigkeitstyp dotiert. Durch Dotierung des Siliziumsubstrats vom zweiten Leitfähigkeitstyp wird eine Isolation des Bauelementes vom Substrat erzielt.

Gemäß einer weiteren Ausführungsform der Erfindung werden die hochdotierten Gebiete in eine dotierte Siliziumschicht mit einer Dotierstoffkonzentration im Bereich zwischen 10¹⁵ und 10¹⁸ cm⁻³ eindiffundiert. Dabei ist ein erstes hochdotiertes Gebiet ringförmig von einem zweiten hochdotierten Gebiet umgeben. Der zwischen dem ersten hochdotierten Gebiet und dem zweiten hochdotierten Gebiet angeordnete Anteil der dotierten Siliziumschicht bildet dabei das schwach dotierte Gebiet. Das erste hochdotierte Gebiet weist eine geringere Tiefe auf, als es der Dicke der dotierten Siliziumschicht entspricht. Das zweite hochdotierte Gebiet weist eine Tiefe auf, die im wesentlichen der Dicke der dotierten Siliziumschicht entspricht. Vor der anodischen Ätzung wird an der Oberfläche der hochdotierten Gebiete eine strukturierte Schutzschicht erzeugt, die das schwach dotierte Gebiet unbedeckt läßt. Die Schutzschicht verhindert bei der anodischen Ätzung einen Ätzangriff an der Oberfläche der hochdotierten Gebiete. Auf diese Weise wird nur das schwach dotierte Gebiet in poröses Silizium verwandelt. Lediglich an den Grenzflächen zwischen dem schwach dotierten Gebiet und den hochdotierten Gebieten kommt es zur Ausbildung von Kanälen mit Durchmessern im Bereich zwischen 10 nm und 100 nm.

Werden die hochdotierten Gebiete von entgegengesetzten Leitfähigkeitstypen dotiert, so entsteht eine Lumineszenzdiode. Werden dagegen die beiden hochdotierten Gebiete vom selben Leitfähigkeitstyp dotiert und ist das schwach dotierte Gebiet vom entgegengesetzten Leitfähigkeitstyp dotiert, kann das entstehende Bauelement durch Aufbringen entsprechender Kontakte als Bipolartransistor betrieben werden.

Weitere Ausgestaltungen der Erfindung gehen aus den übrigen Ansprüchen hervor.

Im folgenden wird die Erfindung anhand der Ausführungsbeispiele und der Figuren näher erläutert.

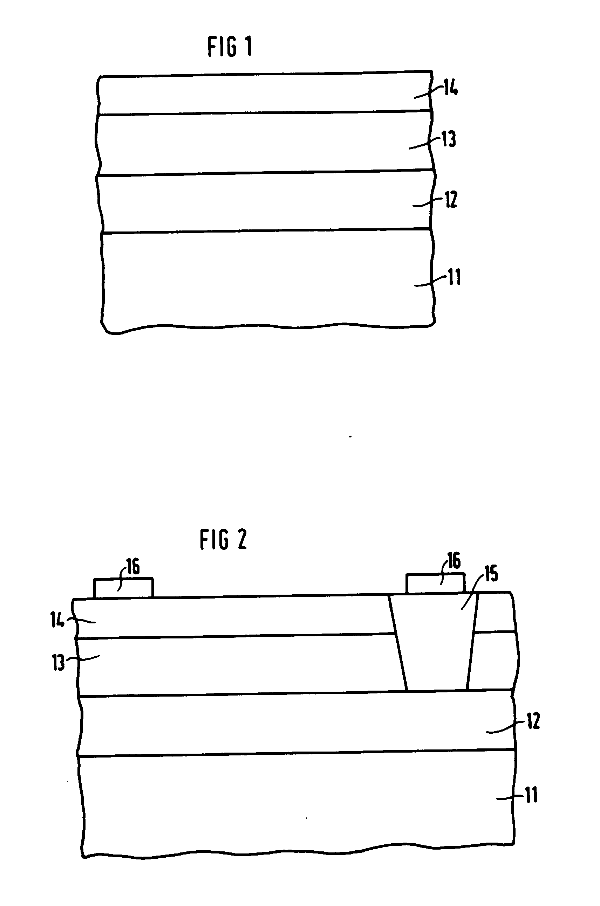

- Fig. 1 und Fig. 2: zeigt die Herstellung eines Bauelementes mit porösem Silizium, in dem die hochdotierten Gebiete und das schwach dotierte Gebiet in vertikaler Reihenfolge angeordnet sind.
- Fig. 3: zeigt die Herstellung eines Bauelementes, bei dem die hochdotierten Gebiete und das schwach dotierte Gebiet in lateraler Richtung angeordnet sind.
- Fig. 4: zeigt die Herstellung eines Bipolartransistors.

An der Oberfläche eines Siliziumsubstrats 11 wird eine erste Schicht 12 erzeugt. Das Siliziumsubstrat 11 ist z. B. p-dotiert und weist eine Dotierstoffkonzentration von 10¹⁵ bis 10¹⁸ cm⁻³ auf.

Die erste Schicht 12 ist z. B. n⁺-dotiert und weiste eine Dotierstoffkonzentration von 10¹⁹ bis 10²¹ cm⁻³ auf. Die erste Schicht 12 bildet ein erstes hochdotiertes Gebiet. Die erste Schicht 12 wird z. B. epitaktisch, durch Implantation oder durch Belegung gebildet. Die erste Schicht 12 weist eine Dicke von z. B. 400 nm bis 10 µm auf.

Auf die erste Schicht 12 wird eine zweite Schicht 13 epitaktisch aufgebracht. Die zweite Schicht 13 ist z. B. p-dotiert und weist eine Dotierstoffkonzentration von 10¹⁵ bis 10¹⁸ cm⁻³ auf. Die zweite Schicht 13 weist eine Dicke von z. B. 100 nm bis 2 µm, vorzugsweise von 600 nm auf.

An der Oberfläche der zweiten Schicht 13 wird eine dritte Schicht 14 z. B. epitaktisch, durch Implantation oder durch Belegung erzeugt. Die dritte Schicht 14 wird p⁺-dotiert und weist eine Dotierstoffkonzentration von mehr als 10¹⁹ cm⁻³ auf. Die Dicke der dritten Schicht 14 beträgt z. B. 100 nm bis 600 nm, vorzugsweise 400 nm.

Das Silizumsubstrat 11 mit der ersten Schicht 12, der zweiten Schicht 13 und der dritten Schicht 14 wird mit einem fluoridhaltigen, sauren Elektrolyten so in Kontakt gebracht, daß die Oberfläche der dritten Schicht 14 vollständig benetzt. Das Siliziumsubstrat 11 wird als Anode verschaltet, der Elektrolyt als Kathode. Es wird eine anodische Ätzung durchgeführt, bei der in der dritten Schicht 14 Kanäle mit Durchmessern im Bereich 10 nm bis 100 nm entstehen. In der zweiten Schicht 13 verzweigen sich diese Kanäle aufgrund der dort vorherrschenden, geringeren Dotierstoffkonzentration zu Kanälen mit 1 bis 2 nm Durchmesser. Die anodische Ätzung wird solange durchgeführt, bis die zweite Schicht 13 vollständig in poröses Silizium umgewandelt ist.

Um die erste Schicht 12 von der Oberfläche der dritten Schicht 14 her kontaktieren zu können, wird z. B. durch maskierte Implantation ein tiefreichender Anschluß 15, der durch die dritte Schicht 14 und die zweite Schicht 13 auf die erste Schicht 12 reicht, hergestellt.

An der Oberfläche der dritten Schicht 14 und des Anschlusses 15 werden je ein Kontakt 16 z. B. durch Aufdampfen von Gold hergestellt (s. Fig. 2).

Durch Anlegen einer positiven Spannung von etwa 2 bis 10 Volt zwischen den Kontakten 16 wird die zweite Schicht 13, die aus porösem Silizium mit Kanälen mit 1 bis 2 nm Durchmesser besteht, mit Elektronen und Löchern überschwemmt und es findet Lichtemission statt.

Das Siliziumsubstrat 11 und die erste Schicht 12 bilden einen pn-Übergang, der das Bauelement vom Siliziumsubstrat 11 isoliert. In Anwendungen, in denen es auf eine solche Isolation nicht ankommt, kann das Silizumsubstrat 11 auch n-dotiert sein.

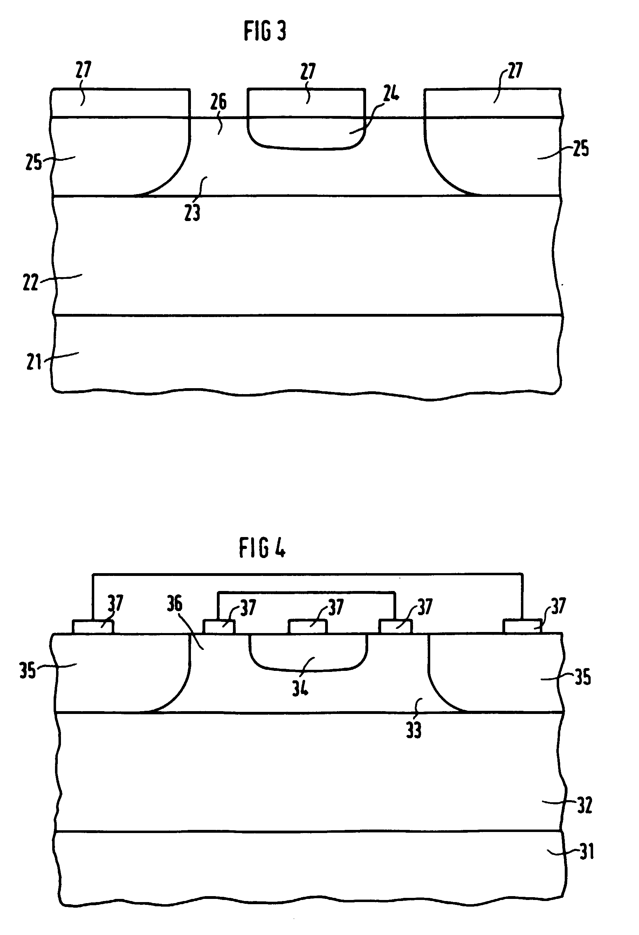

Auf einem Substrat 21 aus einkristallinem Silizium, das z. B. p-dotiert ist und eine Dotierstoffkonzentration von 10¹⁵ bis 10¹⁸ cm⁻³ aufweist, wird eine vergrabene Schicht 22 erzeugt (s. Fig. 3). Die vergrabene Schicht 22 ist z. B. n⁺-dotiert. Sie weist eine Dotierstoffkonzentration von 10¹⁹ - 10²⁰ cm⁻³ auf. Die vergrabene Schicht 22 wird z. B. epitaktisch, durch Implantation oder Belegung gebildet.

An der Oberfläche der vergrabenen Schicht 22 wird durch Epitaxie eine dotierte Siliziumschicht 23 erzeugt. Die dotierte Siliziumschicht 23 ist z. B. p-dotiert und weist eine Dotierstoffkonzentration von 10¹⁵ bis 10¹⁸ cm⁻³ auf.

In der dotierten Siliziumschicht 23 wird ein erstes hochdotiertes Gebiet 24 z. B. durch Eindiffusion erzeugt. Das erste hochdotierte Gebiet 24 ist z. B. p⁺-dotiert und weist eine Dotierstoffkonzentration von mindestens 10¹⁹ cm⁻³ auf.

In der dotierten Siliziumschicht 23 wird ein zweites hochdotiertes Gebiet 25 z. B. durch Diffusion erzeugt. Das zweite hochdotierte Gebiet 25 umgibt z. B. das erste hochdotierte Gebiet 24 ringförmig. Das zweite hochdotierte Gebiet 25 ist z. B. n⁺-dotiert und weist eine Dotierstoffkonzentration von mindestens 10¹⁹ cm⁻³ auf. Der zwischen dem ersten hochdotierten Gebiet 24 und dem zweiten hochdotierten Gebiet 25 angeordnete Anteil der dotierten Siliziumschicht 23 bildet ein schwach dotiertes Gebiet 26. An der Oberfläche der hochdotierten Gebiete 24, 25 wird eine strukturierte Schutzschicht 27 erzeugt, die z. B. aus Fotolack besteht. Die strukturierte Schutzschicht 27 läßt die Oberfläche des schwach dotierten Gebietes 26 unbedeckt.

Das erste hochdotierte Gebiet 24 weist eine geringere Tiefe auf als die dotierte Siliziumschicht 23, so daß das erste hochdotierte Gebiet 24 von der vergrabenen Schicht 22 durch die dotierte Siliziumschicht 23 getrennt ist. Das zweite hochdotierte Gebiet 25 weist eine Tiefe auf, die im wesentlichen der Dicke der dotierten Siliziumschicht 23 entspricht, so daß das zweite hochdotierte Gebiet 25 mit der vergrabenen Schicht 22 in Verbindung steht.

Die Oberfläche des schwach dotierten Gebietes 26 und der Schutzschicht 27 wird mit einem sauren, fluoridhaltigen Elektrolyten in Kontakt gebracht. Das Substrat 21 wird dabei als Anode, der Elektrolyt als Kathode verschaltet. Es erfolgt eine anodische Ätzung, bei der das schwach dotierte Gebiet 26 in poröses Silizium mit Kanälen mit Durchmessern im Bereich 1 bis 2 nm umgewandelt wird. Hierbei können an der Grenzfläche zwischen dem schwach dotierten Gebiet 26 und den hochdotierten Gebieten 24 und 25 ebenfalls Kanäle mit 10 nm bis 100 nm Durchmesser entstehen. Die anodische Ätzung wird vorzugsweise mit folgenden Parametern durchgeführt:
Fluoridkonzentration: 10 %
Stromdichte: 30 mA/cm²
Ätzdauer: beispielsweise für 600 nm 20 sec
Beleuchtung von der Rückseite: ca. 100 mW/cm² (weißes Licht)

Nach Entfernen der Schutzschicht 27 (nicht dargestellt) werden an der Oberfläche des ersten hochdotierten Gebietes 24 und des zweiten hochdotierten Gebietes 25 Kontakte z. B. durch Aufdampfen von Aluminium erzeugt.

Das fertige Bauelement ist durch den n⁺p-Übergang an der Grenzfläche zwischen Substrat 21 und vergrabene Schicht 22 im Substrat 21 isoliert.

Auf ein Substrat 31 aus einkristallinem Silizium, das z. B. p-dotiert ist und eine Dotierstoffkonzentration von z. B. 10¹⁵ - 10¹⁸ cm⁻³ aufweist, wird eine vergrabene Schicht 32 erzeugt (s. Fig. 4). Die vergrabene Schicht 32 ist z. B. n⁺-dotiert und weist eine Dotierstoffkonzentration von mindestens 10¹⁹ cm⁻³ auf. Die vergrabene Schicht 32 wird in einer Dicke von z. B. 400 nm - 2 µm z. B. durch Epitaxie, Implantation oder Belegung gebildet. Auf die vergrabene Schicht 32 wird durch Epitaxie eine dotierte Siliziumschicht 33 aufgebracht. Die dotierte Siliziumschicht 33 ist z. B. p-dotiert und weist eine Dotierstoffkonzentration im Bereich zwischen 10¹⁵ und 10¹⁸ cm⁻³ auf.

Durch Diffusion wird an der Oberfläche der dotierten Siliziumschicht 33 ein erstes hochdotiertes Gebiet 34 erzeugt. Das erste hochdotierte Gebiet 34 ist n⁺-dotiert und weist eine Dotierstoffkonzentration von mindestens 10¹⁹ cm⁻³ auf. Das erste hochdotierte Gebiet 34 weist eine Tiefe auf, die geringer ist als die Dicke der dotierten Siliziumschicht 33, so daß das erste hochdotierte Gebiet 34 durch die dotierte Siliziumschicht 33 von der vergrabenen Schicht 32 getrennt ist.

Es wird durch Diffusion ein zweites hochdotiertes Gebiet 35 in der dotierten Siliziumschicht 33 erzeugt. Das zweite hochdotierte Gebiet 35 ist n⁺-dotiert und weist eine Dotierstoffkonzentration von mindestens 10¹⁹ cm⁻³ auf. Das zweite hochdotierte Gebiet 35 umgibt das erste hochdotierte Gebiet 34 ringförmig. Das zweite hochdotierte Gebiet 35 weist eine Tiefe auf, die im wesentlichen der Dicke der dotierten Siliziumschicht 33 entspricht. Daher steht das zweite hochdotierte Gebiet 35 mit der vergrabenen Schicht 32 in Verbindung. Derjenige Anteil der dotierten Siliziumschicht 33, der zwischen dem ersten hochdotierten Gebiet 34 und dem zweiten hochdotierten Gebiet 35 angeordnet ist, bildet ein schwach dotiertes Gebiet 36.

An der Oberfläche des ersten hochdotierten Gebietes 34 und des zweiten hochdotierten Gebietes 35 wird eine strukturierte Schutzschicht (nicht dargestellt) aus z. B. Fotolack erzeugt. Die Schutzschicht läßt die Oberfläche des schwach dotierten Gebietes 36 unbedeckt. Die Oberfläche des schwach dotierten Gebietes 36 und der Schutzschicht werden mit einem fluoridhaltigen, sauren Elektrolyten in Kontakt gebracht. Dabei wird der Elektrolyt als Kathode und das Substrat 31 als Anode verschaltet. Durch anodische Ätzung werden in dem schwach dotierten Gebiet 36 Kanäle mit Durchmessern im Bereich 1 bis 2 nm erzeugt. Es entsteht poröses Silizium. Die strukturierte Schutzschicht verhindert einen Ätzangriff an der Oberfläche des ersten hochdotierten Gebietes 34 und des zweiten hochdotierten Gebietes 35. An den Grenzflächen des schwach dotierten Gebietes 36 zu dem ersten hochdotierten Gebiet 34 und dem zweiten hochdotierten Gebiet 35 kann es dabei zur Bildung von Kanälen mit Durchmessern im Bereich 10 nm bis 100 nm kommen.

Die anodische Ätzung erfolgt vorzugsweise mit folgenden
Parametern:
Flußsäurekonzentration: 10 %
Stromdichte: 30 mA/cm²
Spannung: einige Volt abhängig von der Stromdichte
Ätzdauer: z. B. für 600 nm 20 sec
Beleuchtung von der Rückseite: ca. 100 mW/cm²

Nach Entfernen der Schutzschicht werden an der Oberfläche des ersten hochdotierten Gebietes 34, des schwach dotierten Gebietes 36 und des zweiten hochdotierten Gebietes 35 Kontakte 37 aufgebracht. Die Kontakte 37 werden z. B. durch Aufdampfen von Aluminium erzeugt.

Das in Fig. 4 dargestellte fertige Bauelement kann als Bipolartransistor betrieben werden. Dabei wirkt das erste hochdotierte Gebiet 34 als Kollektor, das schwach dotierte Gebiet 36, das bei der anodischen Ätzung in poröses Silizium umgewandelt wurde als Basis und das zweite hochdotierte Gebiet 35 als Emitter. Die Kontakte auf dem schwach dotierten Gebiet 36 sowie die Kontakte auf dem zweiten hochdotierten Gebiet 35 sind jeweils miteinander verbunden. Der Bipolartransistor kann über die Basis durch Lichteinstrahlung gesteuert werden.

## Patentansprüche

1. Verfahren zur Herstellung eines Bauelementes mit porösem Silizium,
- bei dem in einer Siliziumscheibe aus einkristallinem Silizium ein schwach dotiertes Gebiet (13, 26, 36) mit einer Dotierstoffkonzentration im Bereich zwischen 10¹⁵ und 10¹⁸ cm⁻³ und hochdotierte Gebiete (12, 14; 24, 25; 34, 35) mit einer Dotierstoffkonzentration im Bereich zwischen 10¹⁹ und 10²¹ cm⁻³ erzeugt werden, wobei mindestens ein hochdotiertes Gebiet vom entgegengesetzten Leitfähigkeitstyp wie das schwach dotierte Gebiet dotiert ist und wobei die hochdotierten Gebiete so angeordnet sind, daß ein Stromfluß zwischen den hochdotierten Gebieten das schwach dotierte Gebiet durch-queren kann,
- bei dem in einem fluoridhaltigen, sauren Elektrolyten, mit dem die Siliziumscheibe in Kontakt steht und in dem die Siliziumscheibe als Anode verschaltet ist, eine anodische Ätzung durchgeführt wird, bei der in dem schwach dotierten Gebiet das Silizium in poröses Silizium umgewandelt wird,
- bei dem die hochdotierten Gebiete jeweils mit Kontakten versehen werden.

2. Verfahren nach Anspruch 1,
bei dem die anodische Ätzung in HF-Lösung bei folgenden Parametern:
Konzentration der HF-Lösung: 5 bis 50 Gewichtsprozent HF
Stromdichte: 1 - 1000 mA/cm²
Spannung: einige Volt
und unter Beleuchtung der Rückseite der Siliziumscheibe durchgeführt wird.

3. Verfahren nach Anspruch 1 oder 2,
- bei dem an der Oberfläche eines Siliziumsubstrats (11) eine erste Schicht (12) erzeugt wird, die von einem ersten Leitfähigkeitstyp dotiert ist und die eine Dotierstoffkonzentration im Bereich zwischen 10¹⁹ und 10²¹ cm⁻3 aufweist,
- bei dem durch Epitaxie auf der ersten Schicht (12) eine zweite Schicht (13) erzeugt wird, die von einem zweiten, zum ersten entgegengesetzten Leitfähigkeitstyp dotiert wird und die eine Dotierstoffkonzentration im Bereich zwischen 10¹⁵ und 10¹⁸ cm⁻³ aufweist,
- bei dem auf der zweiten Schicht (13) eine dritte Schicht (14) erzeugt wird, die vom zeiten Leitfähigkeitstyp mit einer Dotierstoffkonzentration von mindestens 10¹⁹ cm⁻³ dotiert wird,
- bei dem die erste Schicht (12) und die dritte Schicht (14) als hochdotierte Gebiete wirken und die zweite Schicht (13) als schwach dotiertes Gebiet wirkt,
- bei dem zur anodischen Ätzung die Oberfläche der dritten Schicht (14) mit dem Elektrolyten in Kontakt gebracht wird.

4. Verfahren nach Anspruch 3,
- bei dem die erste Schicht in einer Dicke im Bereich zwischen 400 nm und 10 µm erzeugt wird,
- bei dem die zweite Schicht in einer Dicke im Bereich zwischen 100 nm und 600 nm erzeugt wird,
- bei dem die dritte Schicht in einer Dicke im Bereich zwischen 100 nm und 600 nm erzeugt wird.

5. Verfahren nach Anspruch 3 oder 4,
bei dem das Siliziumsubstrat vom zweiten Leitfähigkeitstyp dotiert ist.

6. Verfahren nach einem der Ansprüche 3 bis 5,
bei dem durch die dritte Schicht (14) und die zweite Schicht (13) ein Anschluß (15) zur ersten Schicht gebildet wird, über den die erste Schicht (12) kontaktierbar ist.

7. Verfahren nach Anspruch 1 oder 2,
- bei dem an der Oberfläche eines Siliziumsubstrats (21, 31), das von einem ersten Leitfähigkeitstyp dotiert ist, eine vergrabene Schicht (22, 32) erzeugt wird,
- die von einem zweiten zum ersten entgegengesetzten Leitfähigkeitstyp mit einer Dotierstoffkonzentration größer 10¹⁸ cm⁻³ dotiert ist,
- bei dem auf die vergrabene Schicht (22, 32) epitaktisch eine dotierte Siliziumschicht (23, 33) aufgebracht wird, die eine Dotierstoffkonzentration im Bereich zwischen 10¹⁵ und 10¹⁸ cm⁻³ aufweist,
- bei dem in der dotierten Siliziumschicht (23, 33) die hochdotierten Gebiete eindiffundiert werden, wobei ein erstes hochdotiertes Gebiet (24, 34) ringförmig von einem zweiten hochdotierten Gebiet (25, 35), das vom zweiten Leitfähigkeitstyp dotiert ist, umgeben ist, wobei der zwischen dem ersten hochdotierten Gebiet (24, 34) und den zweiten hochdotierten Gebiet (25, 35) angeordnete Anteil der dotierten Siliziumschicht (23, 33) das schwach dotierte Gebiet (26, 36) bildet, wobei das erste hochdotierte Gebiet (24, 34) eine geringere Tiefe aufweist, als es der Dicke der dotierten Siliziumschicht (23, 33) entspricht und wobei das zweite hochdotierte Gebiet (25, 35) eine Tiefe aufweist, die im wesentlichen der Dicke der dotierten Siliziumschicht (23, 33) entspricht,
- bei dem an der Oberfläche der hochdotierten Gebiete (24, 25; 34, 35) eine strukturierte Schutzschicht (27) erzeugt wird, die das schwach dotierte Gebiet (26, 36) unbedeckt läßt,
- bei dem zur anodischen Ätzung die Oberfläche des schwach dotierten Gebietes (26, 36) und der Schutzschicht mit dem Elektrolyten in Kontakt gebracht werden, wobei die Schutzschicht einen Ätzangriff an der Oberfläche der hochdotierten Gebiete (24, 25; 34, 35) verhindert,
- bei dem die Schutzschicht vor dem Aufbringen der Kontakte entfernt wird.

8. Verfahren nach Anspruch 7,
bei dem die Schutzschicht (27) aus Fotolack gebildet wird.

9. Verfahren nach Anspruch 7 oder 8,
bei dem das erste hochdotierte Gebiet (24) vom ersten Leitfähigkeitstyp dotiert wird und die Siliziumschicht (23) vom zweiten Leitfähigkeitstyp dotiert wird.

10. Verfahren nach Anspruch 7 oder 8,
- bei dem das erste hochdotierte Gebiet (34) vom zweiten Leitfähigkeitstyp dotiert wird,
- bei dem die Siliziumschicht (33) vom ersten Leitfähigkeitstyp dotiert wird,
- bei dem zusätzlich zu den Kontakten zu den hochdotierten Gebieten ein Kontakt zu dem schwach dotierten Gebiet gebildet wird.

## Claims

1. Method for producing a component with porous silicon,
- in which a weakly doped region (13, 26, 36) with a dopant concentration in the range between 10¹⁵ and 10¹⁸ cm⁻³ and heavily doped regions (12, 14; 24, 25; 34, 35) with a dopant concentration in the range between 10¹⁹ and 10²¹ cm⁻³ are produced in a silicon wafer made of monocrystalline silicon, at least one heavily doped region being of the opposite conductivity type to the weakly doped region, and the heavily doped regions being arranged in such a way that a current flow between the heavily doped regions can pass through the weakly doped region,
- in which anodic etching, in which the silicon is converted into porous silicon in the weakly doped region, is carried out in a fluoride-containing acidic electrolyte, with which the silicon wafer is in contact and in which the silicon wafer is connected as the anode,
- in which the heavily doped regions are each provided with contacts.

2. Method according to Claim 1, in which the anodic etching is carried out in HF solution with the following parameters:
Concentration of the HF solution: 5 to 50 per cent by weight of HF
Current density: 1 - 1000 mA/cm²
Voltage: a few volts
and with illumination of the rear side of the silicon wafer.

3. Method according to Claim 1 or 2,
- in which a first layer (12), which is doped with a first conductivity type and has a dopant concentration in the range between 10¹⁹ and 10²¹ cm⁻², is produced on the surface of a silicon substrate (11),
- in which a second layer (13), which is doped with a second conductivity type, opposite to the first, and has a dopant concentration in the range between 10¹⁵ and 10¹⁸ cm⁻³, is produced by epitaxy on the first layer (12),
- in which a third layer (14), which is doped with the second conductivity type with a dopant concentration of at least 10¹⁹ cm⁻³, is produced on the second layer (13),
- in which the first layer (12) and the third layer (14) act as heavily doped regions and the second layer (13) acts as the weakly doped region, and
- in which the surface of the third layer (14) is brought into contact with the electrolyte for the purpose of anodic etching.

4. Method according to Claim 3,
- in which the first layer is produced with a thickness in the range between 400 nm and 10 µm,
- in which the second layer is produced with a thickness in the range between 100 nm and 600 nm,
- in which the third layer is produced with a thickness in the range between 100 nm and 600 nm,

5. Method according to Claim 3 or 4, in which the silicon substrate is doped with the second conductivity type.

6. Method according to one of Claims 3 to 5, in which a connection (15) to the first layer, via which contact can be made with the first layer (12), is formed through the third layer (14) and the second layer (13).

7. Method according to Claim 1 or 2,
- in which, on the surface of a silicon substrate (21, 31), which is doped with a first conductivity type, a buried layer (22, 32) is produced,
- which is doped with a second conductivity type, opposite to the first, with a dopant concentration of greater than 10¹⁸ cm⁻³,
- in which a doped silicon layer (23, 33), which has a dopant concentration in the range between 10¹⁵ and 10¹⁸ cm⁻³, is epitaxially applied onto the buried layer (22, 32),
- in which the heavily doped regions are diffused in the doped silicon layer (23, 33), a first heavily doped region (24, 34) being annularly surrounded by a second heavily doped region (25, 35) which is doped with the second conductivity type, the part of the doped silicon layer (23, 33) arranged between the first heavily doped region (24, 34) and the second heavily doped region (25, 35) forming the weakly doped region (26, 36), the first heavily doped region (24, 34) having a depth less than that corresponding to the thickness of the doped silicon layer (23, 33), and the second heavily doped region (25, 35) having a depth which essentially corresponds to the thickness of the doped silicon layer (23, 33),
- in which a structured protective layer (27) which leaves the weakly doped region (26, 36) uncovered is produced on the surface of the heavily doped regions (24, 25; 34, 35),
- in which for anodic etching, the surface of the weakly doped region (26, 36) and of the protective layer are brought into contact with the electrolyte, the protective layer preventing etching attack on the surface of the heavily doped regions (24, 25; 34, 35),
- in which the protective layer is removed before the contacts are applied.

8. Method according to Claim 7, in which the protective layer (27) is formed from photoresist.

9. Method according to Claim 7 or 8, in which the first heavily doped region (24) is doped with the first conductivity type and the silicon layer (23) is doped with the second conductivity type.

10. Method according to Claim 7 or 8,
- in which the first heavily doped region (34) is doped with the second conductivity type,
- in which the silicon layer (33) is doped with the first conductivity type,
- in which, in addition to the contacts to the heavily doped regions, a contact to the weakly doped region is formed.

## Revendications

1. Méthode de fabrication d'un dispositif comportant du silicium poreux,
- dans laquelle, dans une pastille de silicium en silicium monocristallin, on forme une région faiblement dopée (13, 26, 36) avec une concentration en agent de dopage dans le domaine entre 10¹⁵ et 10¹⁸ cm⁻³, et des régions fortement dopées (12, 14; 24, 25; 34, 35) avec une concentration en agent de dopage dans le domaine entre 10¹⁹ et 10²¹ cm⁻³, le type de conductibilité du dopage d'au moins une région fortement dopée étant opposé à celui de la région faiblement dopée, et les régions fortement dopées étant disposées de telle sorte qu'une conduction de courant peut traverser la région faiblement dopée entre les régions fortement dopées,
- dans laquelle, dans un électrolyte acide contenant du fluorure avec lequel la pastille de silicium se trouve en contact et dans lequel la pastille de silicium est montée en forme d'anode, on procède à une gravure anodique dans laquelle, dans la région faiblement dopée, le silicium est transformé en silicium poreux,
- dans laquelle, les régions fortement dopées sont munies respectivement de contacts.

2. Méthode selon la revendication 1,
dans laquelle on effectue la gravure anodique dans une solution de HF avec les paramètres ci-après:
concentration de la solution de HF: de 5 à 50 pour cent en poids de HF
densité de courant: 1 - 1000 mA/cm²
tension: quelques volts
et en éclairant le côté dorsal de la pastille de silicium.

3. Méthode selon la revendication 1 ou 2,
- dans laquelle, à la surface d'un substrat de silicium (11), on forme une première couche (12) dont le dopage est d'un premier type de conductibilité et qui présente une concentration en agent de dopage dans le domaine entre 10¹⁹ et 10²¹ cm⁻³,
- dans laquelle, par épitaxie sur la première couche (12), on forme une deuxième couche (13) dont le dopage est d'un second type de conductibilité opposé au premier et qui présente une concentration en agent de dopage dans le domaine entre 10¹⁵ et 10¹⁸ cm⁻³,
- dans laquelle, sur la deuxième couche (13), on forme une troisième couche (14) dont le dopage est du second type de conductibilité avec une concentration en agent de dopage d'au moins 10¹⁹ cm-³,
- dans laquelle la première couche (12) et la troisième couche (14) font office de régions fortement dopées et la deuxième couche (13) fait office de couche faiblement dopée,
- dans laquelle, pour la gravure anodique, on met la surface de la troisième couche (14) en contact avec l'électrolyte.

4. Méthode selon la revendication 3,
- dans laquelle on forme la première couche en une épaisseur dans le domaine entre 400 nm et 10 µm,
- dans laquelle on forme la deuxième couche avec une épaisseur dans le domaine entre 100 nm et 600 nm,
- dans laquelle on forme la troisième couche avec une épaisseur dans le domaine entre 100 nm et 600 nm,

5. Méthode selon la revendication 3 ou 4,
dans laquelle le dopage du substrat de silicium est du second type de conductibilité.

6. Méthode selon l'une quelconque des revendications 3 à 5, dans laquelle, à travers la troisième couche (14) et la deuxième couche (13), on forme un raccord (15) en direction de la première couche, à l'aide duquel la première couche (12) peut être mise en contact.

7. Méthode selon la revendication 1 ou 2,
- dans laquelle, à la surface d'un substrat de silicium (21, 31) dont le dopage est d'un premier type de conductibilité, on forme une couche enfouie (22, 32), dont le dopage est d'un second type de conductibilité opposé au premier, avec une concentration en agent de dopage supérieure à 10¹⁸ cm⁻³,
- dans laquelle, sur la couche enfouie (22, 32), on applique par épitaxie une couche de silicium dopée (23, 33) qui présente une concentration en agent de dopage dans le domaine entre 10¹⁵ et 10¹⁸ cm⁻³,
- dans laquelle, dans la couche de silicium dopée (23, 33), on introduit par diffusion les régions fortement dopées, une première région fortement dopée (24, 34) étant entourée à la manière d'un anneau par une deuxième région fortement dopée (25, 35) dont le dopage est du second type de conductibilité, la fraction de la couche de silicium dopée (23, 33) disposée entre la première région fortement dopée (24, 34) et la deuxième région fortement dopée (25, 35), forme la région faiblement dopée (26, 36), la première région fortement dopée (24, 34) présentant une profondeur inférieure à celle qui correspond à l'épaisseur de la couche de silicium dopée (23, 33) et la deuxième région fortement dopée (25, 35) présentant une profondeur qui correspond essentiellement à l'épaisseur de la couche de silicium dopée (23, 33),
- dans laquelle, à la surface des régions fortement dopées (24, 25; 34, 35), on forme une couche de protection structurée (27) qui met à nu la région faiblement dopée (26, 36),
- dans laquelle, pour la gravure anodique, on amène les surfaces de la région faiblement dopée (26, 36) et de la couche de protection en contact avec l'électrolyte, la couche de protection empêchant une attaque par gravure à la surface des régions fortement dopées (24, 25; 34, 35),
- dans laquelle on élimine la couche de protection avant l'application des contacts.

8. Méthode selon la revendication 7,
dans laquelle on forme la couche de protection (27) à partir de photolaque.

9. Méthode selon la revendication 7 ou 8,
dans laquelle le dopage de la première région fortement dopée (24) est du premier type de conductibilité et le dopage de la couche de silicium (23) est du second type de conductibilité.

10. Méthode selon la revendication 7 ou 8,
- dans laquelle le dopage de la première région fortement dopée (34) est du second type de conductibilité,
- dans laquelle le dopage de la couche de silicium (33) est du premier type de conductibilité,
- dans laquelle, en plus des contacts par rapport aux régions fortement dopées, on forme un contact par rapport à la région faiblement dopée.
